# EUROPÄISCHE PATENTANMELDUNG

(11) **EP 0 669 723 A1**
(43) Veröffentlichungstag der Anmeldung: **30.08.1995**
(21) Anmeldenummer: 94119929.1
(22) Anmeldetag: 16.12.1994
(51) Int. Cl.: H03M 1/66, H03M 1/06

(54) **D/A-Wandler mit erhöhter Auflösung**

(30) Priorität: 28.02.1994 DE 4406326
(71) Anmelder: ROBERT BOSCH GMBH, 70442 Stuttgart (DE)
(72) Erfinder: Grotz, Karlheinz, D-70734 Fellbach (DE); Mayer, Jörg, D-70374 Stuttgart (DE)

(57) **Zusammenfassung**

Bei einem schnellen D/A-Wandler mit hoher Auflösung werden parallel arbeitende D/A-Wandlerstufen (DAC1, DAC2, DAC3, ... DACn) eingesetzt. Diese D/A-Wandlerstufen werden mit jeweils unterschiedlichen Gleichspannungsoffsets (01, 02, 03, ... On) beaufschlagt. Die Auswirkungen systematischer Fehlerspannungen können auf diese Weise vermindert werden.

## Beschreibung

Die Erfindung betrifft einen D/A-Wandler, der aus mehreren parallel geschalteten D/A-Wandlerstufen besteht.

Zur Erzielung schneller D/A-Wandler mit hoher Auflösung sind mehre Lösungen bekannt. Es werden mehrere D/A-Wandler parallel betrieben und deren Ausgangssignale summiert. Die Eingangssignale dieser D/A-Wandler werden bezüglich des Quantisierungsbereichs des zu wandelnden Eingangssignals unterteilt. (WO 92/02987 A1, EP 66 251 B1, EP 280 321 A2, DE 43 20 691 A1 Diese Verfahren benötigen eingangsseitig einen Decoder zur Bildung unterschiedlicher Gruppen von Quantisierungsbereichen oder zumindest eine Datenselektionsstufe.

Aufgabe vorliegender Erfindung ist es einen D/A-Wandler ausgehend vom Oberbegriff des Patentanspruchs 1 zu schaffen, welcher bei hoher Auflösung geringe systematische Fehler aufweist. Diese Aufgabe wird durch die Merkmale des Anspruchs 1 gelöst. Die weiteren Ansprüche zeigen vorteilhafte Ausgestaltungen bzw. Anwendungen auf.

Der Erfindung liegen folgende Erkenntnisse Zugrunde: Die meisten handelsüblichen D/A-Wandler weisen, bedingt durch ihre Architektur, systematische Fehler auf, z.B. sogenannte "Glitches" an Stufen der Quantisierungsbereiche. Wenn solche D/A-Wandler zur Erhöhung der Auflösung parallel geschaltet werden, können sich die "Glitches" überlagern und durch die sich anschließende Summierung weiterhin Zu systematischen Fehlern führen. Da erfindungsgemäß jedes Eingangssignal einer D/A-Wandlerstufe mit einem anderen Gleichspannungsoffset beaufschlagt ist, sind die systematischen Fehler verteilt und wirken sich im Ausgangssignal des D/A-Wandlers nur mit jenem Bruchteil aus, der durch die Anzahl N der D/A-Wandlerstufen gegeben ist.

Eine möglichst statistische Verteilung der Offsetwerte liefert eine hohe Unterdrückung systematischer Fehler der einzelnen D/A-Wandlerstufen.

Mit den Maßnahmen der Erfindung läßt sich im S/N-Verhältnis (signal to noise ratio) ein Gewinn von 3 dB je Verdopplung der Anzahl der D/A-Wandlerstufen erreichen. Es können handelsübliche D/A-Wandlerstufen ohne aufwendigen Vorabgleich verwendet werden. Eingangsseitige Decoder oder Selektionsstufen zur Bildung unterschiedlicher Quantisierungsgruppen sind nicht notwendig. Laufzeitprobleme, die insbesondere bei eingangsseitigen Decodern auftreten können, werden vermieden.

Anhand der Zeichnungen werden Ausführungsbeispiele der Erfindung erläutert. Es zeigen
Figur 1 ein Blockschaltbild eines D/A-Wandlers nach der Erfindung,
Figur 2 Ausgangssignale von D/A-Wandlerstufen mit gegeneinander versetzten Offsetsignalen,
Figur 3 ein Ausgangssignal eines D/A-Wandlers nach der Erfindung.

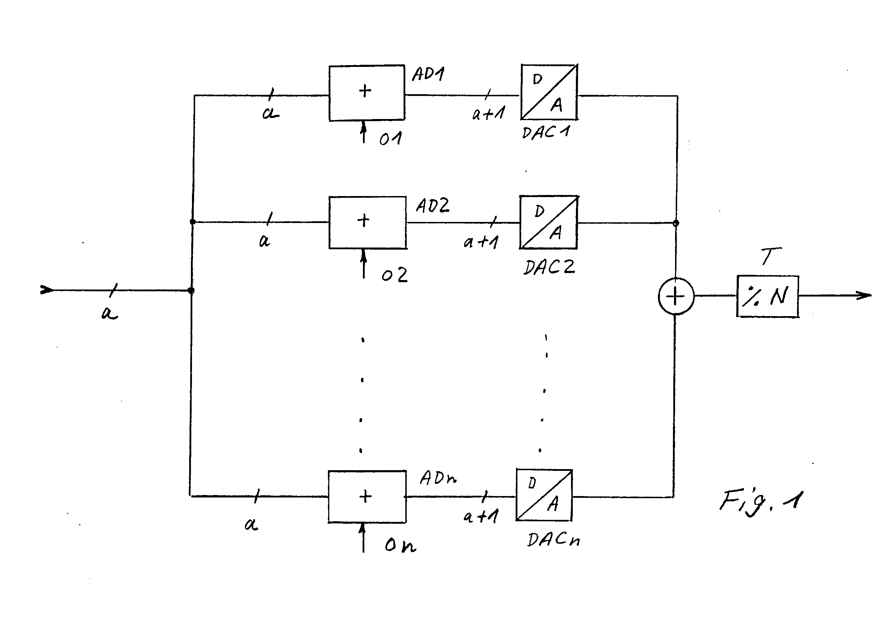

Wie Figur 1 zeigt, besteht der D/A-Wandler nach der Erfindung aus N vorzugsweise gleichartig aufgebauten D/A-Wandlerstufen DAC1, DAC2, DAC3, ... DACn, denen das zu wandelnde digitale Eingangssignal mit einer Wortbreite a von 12 Bit parallel und ohne Zwischenschaltung einer Selektionsstufe für einzelne Quantisierungsgruppen zugeführt wird. Jeder dieser D/A-Wandlerstufen DAC1, DAC2, DAC3, ... DACn ist eine Verknüpfungsstufe AD1, AD2, AD3, ... ADn zugeordnet, insbesondere vorgeschaltet, die mit einem Offset 01, 02, 03, ... On, z.B. einem DC-Wert, beaufschlagt ist.

Diese Gleichspannungsoffset-Werte unterscheiden sich von Wandlerstufe zu Wandlerstufe voneinander. Sie sind insbesondere so gewählt (gleichverteilt), daß die Wahrscheinlichkeit für das Auftreten systematischer Fehlerspannungen, sogenannte Glitches, minimal wird. Die Verknüpfungsstufen AD1, AD2, AD3, ... ADn sind vorzugsweise als Addierer ausgebildet.

Die D/A-Wandlerstufen DAC1, DAC2, DAC3, ... DACn sind so ausgebildet, daß ihre zu verarbeitende Wortbreite a + 1 um mindestens eine Bitposition größer ist als die Wortbreite a des D/A-Wandler-Eingangssignals. Alternativ zur Vergrößerung der Wortbreite kann auch der Aussteuerungsbereich geändert werden. Da die Glitches bedingt durch die Architektur der einzelnen D/A-Wandlerstufen typischerweise bei bestimmten Quantisierungsübergängen auftreten, werden die Gleichspannungsoffsetwerte gegeneinander variiert. Figur 2 zeigt in den Zeilen a bis d ein digitalisiertes Sinussignal von 6MHz mit einer Abtastfrequenz von 452 MHz und ± 8LSB Aussteuerung, welches jeweils mit einem anderen Offsetwert 01, 02,03, ... On beaufschlagt ist.

In Zeile a beträgt der Offsetwert 01 = 1031 Bit, in Zeile b: 02 = 1027 Bit, in Zeile c: 03 = 1019 Bit und in Zeile d: 04 = 1023 Bit.

Die N Ausgangssignale der D/A-Wandlerstufen DAC1, DAC2, DAC3, ... DACn werden vorzugsweise mittels eines Addierers ADD zusammengefaßt. Das Additionssignal wird anschließend mittels einem Teiler T bezüglich seiner Ausgangsspannungs- oder Ausgangsstromamplitude geteilt. Als Teilverhältnis eignet sich insbesondere die Zahl N (Anzahl der einzelnen D/A- Wandlerstufen).

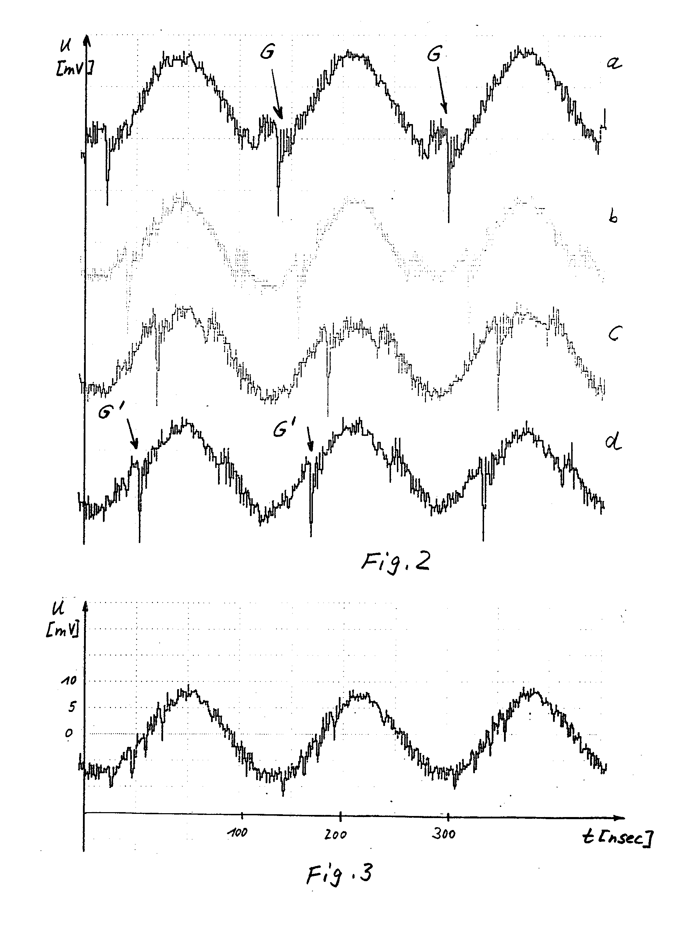

Das Ausgangssignal des Teilers T, d.h. das Ausgangssignal des D/A-Wandlers ist in Figur 3 dargestellt. Es ist durch die systematischen Fehlerspannungen der D/A-Wandlerstufen nur wenig verfälscht, da die Glitches G bzw. G' untereinander aufaddiert werden und ihre Amplitude um den Faktor N im Gesamtsignal abgesenkt ist.

Als systematische Fehler treten insbesondere auf:
- Gain- und Offsetfehler,
- Fehler der differentiellen und integralen Linearität,
- dynamische Fehler (Glitches, Spikes),
- kurzzeitige Spannungseinbrüche.

Alle vorgenannten Fehler werden durch die Maßnahmen der Erfindung in ihrer Auswirkung auf das D/A-Wandler-Ausgangssignals vermindert.

Allgemein läßt sich sagen, daß der Gewinn im S/N-Verhältnis um 3 dB je Verdopplung der Anzahl N der Wandlerstufen steigt.

Der D/A-Wandler nach der Erfindung eignet sich insbesondere zur Verarbeitung von digitalen Videosignalen oder Fernsehsignalen die insbesondere zu Frequenzmultiplex-Kanalbündeln zusammengefaßt sind, wie z.B. bei den Verfahren gemäß DE 41 36 112 A1 oder DE 40 08 201 C2.

Der D/A-Wandler nach der Erfindung eignet sich auch für die direkte digitale Signalerzeugung (direct digital synthesis), beispielsweise für digitale Frequenzgeneratoren (VFOs) oder Radaranwendungen, z.B. zur Chirp-Aufbereitung.

## Patentansprüche

1. D/A-Wandler bestehend aus mehreren parallel geschalteten D/A-Wandlerstufen (DAC1, DAC2, DAC3, ... DACn), dadurch gekennzeichnet, daß den D/A-Wandlerstufen jeweils eine Verknüpfungsstufe (AD1, AD2, AD3, ... ADn) Zugeordnet ist und daß die Verknüpfungsstufen so ausgebildet sind, daß sie jeweils mit dem gleichen D/A-Wandler-Eingangssignal sowie mit einem Offset (01, 02, 03, ... On) beaufschlagbar sind, wobei sich die Offsets der Wandlerstufen voneinander unterscheiden.

2. D/A-Wandler nach Anspruch 1, gekennzeichnet durch die Ausbildung der Verknüpfungsstufen (AD1, AD2, AD3, ... ADn) als Addierer.

3. D/A-Wandler nach Anspruch 1 oder 2, dadurch gekennzeichnet, daß die D/A-Wandlerstufen (DAC1, DAC2, DAC3, ... DACn) so ausgestaltet sind, daß sich ihre zu verarbeitende Wortbreite um mindestens eine Bitposition von der Wortbreite des zuführbaren D/A-Wandler-Eingangssignals unterscheidet.

4. D/A-Wandler nach einem der Ansprüche 1 bis 3, dadurch gekennzeichnet, daß die Ausgänge der D/A-Wandlerstufen (DAC1, DAC2, DAC3, ... DACn) zu einem Addierer (ADD) geführt sind, welcher ausgangsseitig mit einem Teiler (T) für die Ausgangsspannungs- oder Ausgangsstromamplitude des Addiererausgangssignals beschaltet ist.

5. D/A-Wandler nach Anspruch 4, dadurch gekennzeichnet, daß das Teilverhältnis des Teilers (T) entsprechend der Anzahl N der D/A-Wandlerstufen (AD1, AD2, AD3, ... ADn) gewählt ist.

6. D/A-Wandler nach einem der Ansprüche 1 bis 5, dadurch gekennzeichnet, daß die Offset-Werte für die Verknüpfungsstufen/Addierer (AD1, AD2, AD3, ... ADn) so gewählt sind, daß die Wahrscheinlichkeit für das Auftreten systematischer Fehlerspannungen ("Glitches") bezüglich der D/A-Wandlerstufen (DAC1, DAC2, DAC3, ... DACn) minimal ist.

7. Anwendung des Verfahrens nach einem der Ansprüche 1 bis 6 für ein digitales Videosignal bzw. Fernsehsignal insbesondere für ein daraus zusammengesetztes Frequenzmultiplex-Kanal-Bündel.

8. Anwendung des Verfahrens nach einem der Ansprüche 1 bis 6 zur direkten digitalen Signalsynthese.
